# EUROPEAN PATENT APPLICATION

(11) **EP 4 712 697 A1**
(43) Date of publication of application: **18.03.2026**
(21) Application number: 24200666.6
(22) Date of filing: 16.09.2024
(51) Int. Cl.: H05B 45/00, B60Q 3/80, H01R 43/26, H05K 1/02

(54) **AUTOMOTIVE LIGHTING DEVICE FOR INTERIOR LIGHTING**

(71) Applicant: Valeo Vision, 93012 Bobigny Cedex (FR)
(72) Inventor: SANTAELLA, Juan-Jose, MARTOS (ES); MONNOT, Jerome, BOBIGNY (FR); ORTEGA-CABEZAS, Pedro-Miguel, MARTOS (ES)
(74) Representative: Valeo Visibility

(57) **Abstract**

The present invention relates to a luminous device (10) for interior lighting comprising a circuit substrate. The circuit substrate comprises a first circuit, a second circuit and a light source (3). The first circuit comprises a first circuit input (1), a second circuit input (2) and a driver element (20) configured to control the light source (3). The second circuit comprises a first coupling input (4), a second coupling input (5), a first connection (6), a second connection (7), a third connection (8) and a fourth connection (9). The first connection (6), and the second connection (7) provides an electric connection from the first coupling input (4) to the first circuit input (1) and second circuit input (2) respectively, and further comprises a first electric discontinuity (11) and a second electric discontinuity (12) respectively.

## Description

### FIELD OF THE INVENTION

This invention is related to the field of automotive interior lighting, and more particularly, to the improvement of the interior arrangement of these devices, especially the configuration of the connectors.

### BACKGROUND OF THE INVENTION

Automotive lighting market can be considered one of the most competitive ones and new lighting functionalities are constantly required.

Automotive vehicles have interior light sources, which are in charge of providing interior lighting when needed. In current automotive vehicles, these interior lights are used to customize the appearance of the interior of the vehicle, and are increasingly used in doors, dashboards, roofs and so on.

This means that the space available for these devices is reduced, and they must provide a good optical performance with this reduced space. The electronics of this kind of luminous devices include normally a printed circuit board (PCB) with the electronics, and a number of pins, which receive information from a connector which communicates information from the BCM. For example, the PCB may have four pins, each pin configured to receive VCC, GND, LIN_in and LIN_out. The connector configuration is provided by the car manufacturer, and the design and way of providing information in these connectors may be different from one manufacturer to another. Even the distance between connectors (commonly known as "pitch") also varies for different manufacturer.

In view of the above, there is a need in the field of providing a single PCB which can be connected to the connectors of different manufacturers without unnecessarily redesigning elements within the PCB.

### BRIEF DESCRIPTION OF THE INVENTION

The present invention overcomes the above limitations of the prior art, by providing a luminous device for interior lighting of a vehicle according to the invention.

In a first inventive aspect, the invention provides a luminous device for interior lighting of a vehicle, the luminous device comprising a circuit substrate, wherein
the circuit substrate comprises a first circuit, a second circuit and a light source;
the first circuit comprises a first circuit input, a second circuit input and a driver element configured to control the light source;
the second circuit comprises a first coupling input, a second coupling input, a first connection, a second connection, a third connection and a fourth connection;
the first connection provides an electric connection from the first coupling input to the first circuit input and comprises a first electric discontinuity;
the second connection provides an electric connection from the first coupling input to the second circuit input and comprises a second electric discontinuity;
the third connection provides an electric connection from the second coupling input to the first circuit input and comprises a third electric discontinuity; and
the fourth connection provides an electric connection from the second coupling input to the second circuit input and comprises a fourth electric discontinuity.

This interior lighting is intended to receive commands and power supply by a connector, which communicates power and information from the Body Control Module. The connector is designed by the automotive manufacturer, and each automotive manufacturer may define a connector with different features. For example, the automotive manufacturer connector may have a first pin for VCC and a second pin for GND, but a different manufacturer may provide a connector with the first pin for GND and the second pin for VCC. To avoid the provision of one circuit substrate for each different manufacturer, the present invention provides a luminous device which comprises a first coupling input and a second coupling input. These two coupling inputs are intended to couple with the connector provided by the first manufacturer. Needless to say, the connector may have more than two pins and the second circuit of the present invention may comprise more than two coupling inputs, so that each coupling input is connected to one pin of the connector provided by the car manufacturer. But in the more general case, the invention refers to the fact that, taking into account just two coupling inputs, the first coupling input may be directed to the first circuit input or to the second circuit input, just by closing the either the first or the second connection. The same happens with the second coupling input and the third and fourth connections. This invention may be extended to the case of having 4, 8 or any number of pins in the connector provided by the car manufacturer. Since this connector is not part of the invention, the number of coupling inputs is not limited.

Hence, the discontinuities present in each of the first, second, third and fourth connections can be spaces where electric connection is interrupted or open. Each discontinuity may be easily closed by an electronic component, such as a resistor with low ohmic impedance or a jumper. The invention is based on the fact that only desired discontinuities are closed, while the others remain open.

With this invention, design cost and time is reduced, because there is no need of multiple designs of the layout of the printed circuit boards (PCBs) to meet the different designs of the car manufacturer connector. With only one layout, the invention provides a circuit which is valid for different options or designs of the car manufacturer connectors.

In some particular embodiments,
the circuit substrate comprises at least a first layer and a second layer, and
at least one of the first connection, the second connection, the third connection and the fourth connection comprises a via which connects a point in the first layer with a point in the second layer.

The circuit substrate may be a two-layer or three layer or four-layer or multi-layered printed circuit board. The number of layers in the PCB may be used to create multiple circuit paths without electric contact between the different circuit paths. The multi-layered PCB is useful when one conductive track must cross a different conductive track of another circuit path without contacting,. Further, vias are used to change the electric path from one layer to another, to make this crossing without contact possible.

In some particular embodiments, at least one of the first connection, the second connection, the third connection and the fourth connection comprises a jumper installed in the corresponding electric discontinuity, which closes the electric discontinuity.

As indicated above, the circuit as presented in the general definition of the invention is ready to meet the needs of different car manufacturers. The installation of an electronic component, such as a zero ohm resistor or a jumper, in one or more of the electric discontinuities makes the circuit operative to be installed in a vehicle.

In some particular embodiments, the luminous device further comprises an optical element configured to receive the light emitted by the light source.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements which are useful for transforming the light beams emitted by the light source into an acceptable light pattern for the functionality chosen for the lighting device.

In some particular embodiments, the optical element is a lightguide or a reflector or a massive light guide.

Depending on the shape and position of the interior light, a tube-type lightguide, a massive lightguide or a simple reflector will be the best option to achieve the projection of the light emitted by the light sources.

In some particular embodiments, the light source is a solid-state light source, such as a light emitting diode.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas. These light sources are specifically advantageous, since they provide the required luminous properties for the automotive regulations with a high efficiency and reliability.

In some particular embodiments, the at least one light source is configured to cooperate to provide an interior lighting function.

Lighting or signalling functions which require a reduced space will receive a higher benefit from this invention, since heat dissipation requirements are met without the need of substantially increasing the size of the electronic circuit.

In some particular embodiments, the second circuit comprises at least two first pinholes and at least two second pinholes, wherein the first pinholes are electrically connected to the first coupling input and the second pinholes are electrically connected to the second coupling input.

The pinholes are holes configured to receive pins. These pinholes are configured to receive pins which will be connected with the car manufacturer connector, which is usually a female connector. However, in these embodiments, it is advantageous that pins are independent elements, since they can be customized (e.g., bended) to meet the features of the car manufacturer connector. The pinholes are standard for every car manufacturer connector design, and the pins would be the elements which have a design dependent on the car manufacturer connector.

In fact, in a second inventive aspect, the invention provides a luminous device for interior lighting comprising a circuit substrate comprising a first circuit and a second circuit, wherein
the first circuit comprises a first circuit input, a second circuit input and a light source;
the second circuit comprises at least two first pinholes and at least two second pinholes, wherein the first pinholes are electrically connected to the first coupling input and the second pinholes are electrically connected to the second coupling input.

In some particular embodiments, the distance between one of the first pinholes and one of the second pinholes is 2.1 mm. In different embodiments, the distance between one of the first pinholes and one of the second pinholes is 1.8 mm. In different embodiments, the distance between one of the first pinholes and one of the second pinholes is 2.54 mm.

These are common distances in the connectors provided by car manufacturers, so this can enable the device of the invention to match with these connectors.

In some particular embodiments, the luminous device further comprises at least one pin, each pin being inserted in one of the pinholes, wherein the pin comprises an insertion portion and a connection portion, and the connection portion is bended so that the distance between the tips of the connection portions is greater or lower than the distance between the corresponding pinholes.

One way of adapting the luminous device of the invention to different connectors is to customize the shape of the pins which are inserted in the pinholes. These pins have an insertion portion and a connection portion, which has a tip.

In some particular embodiments, the luminous device further comprises a second circuit substrate, and the light source is arranged in the second circuit substrate, and the light source is connected to the driver element by means of a harness. The light source may be, according to the needs of the car manufacturer, far from the driver. In these cases, the light source can be mounted on a separate circuit substrate. However, this does not prevent the device from achieving its aim.

All the terms and embodiments described anywhere in this document are equally applicable to all aspects of the invention. It should be noted that, as used in the specification and in the appended claims, the singular forms "a", "an", and "the" include their plural referents unless the context clearly indicates otherwise. Similarly, the term "comprises" or "comprising" as used herein also describes "consists of" or "consisting of" in accordance with generally accepted patent practice.

### DESCRIPTION OF THE DRAWINGS

The foregoing and other features and advantages will be more fully understood from the detailed description of the invention, as well as from examples referring to the attached figures, which are described in the following paragraphs, wherein:
Figure 1 shows a luminous device according to the invention installed in an automotive vehicle.
Figure 2 shows a general approach of a particular embodiment of a luminous device according to the invention.
Figure 3 shows the electric arrangement of a particular embodiment of a luminous device according to the invention.
Figure 4 shows the electric arrangement of Figure 3 in a particular embodiment of use.
Figure 5 shows the electric arrangement of a different luminous device according to the invention.
Figure 6 shows the electric arrangement of a different luminous device according to the invention.
Figure 7 shows a combination between the arrangement of Figure 4 and the arrangement of Figure 6.

### Numerical references used in the drawings

In order to provide a better understanding of the technical features of the invention, the referred Figures are accompanied by the following numerical references:

| | |
|---|---|
| 1 | First circuit input |
| 2 | Second circuit input |
| 3 | LED |
| 4 | First coupling input |
| 5 | Second coupling input |
| 6 | First connection |
| 7 | Second connection |
| 8 | Third connection |
| 9 | Fourth connection |
| 10 | Luminous device |
| 11 | First electric discontinuity |
| 12 | Second electric discontinuity |
| 13 | Third electric discontinuity |
| 14 | Fourth electric discontinuity |
| 15 | First pinhole |
| 16 | Second pinhole |
| 17 | Lightguide |
| 18 | RGB module |
| 19 | Vehicle connector |
| 20 | Driver element |
| 21 | Harness |
| 22 | Pin |
| 23 | Tip of the pin |
| 100 | Automotive vehicle |

### DETAILED DESCRIPTION OF THE INVENTION

The detailed description of the present invention to be described below refers to the accompanying drawings, which illustrate specific embodiments in which the present invention may be implemented. These embodiments will be described in detail sufficient to enable those skilled in the art to implement the present invention. It should be understood that various embodiments of the present invention are different from each other but need not be mutually exclusive. Accordingly, the detailed description to be described below is not intended to be taken in a limiting meaning, and the scope of the present invention, if properly described, is limited only by the appended claims, in addition to all scopes equivalent to those claimed by the appended claims. In the drawings, reference numerals refer to the same or similar functions over several aspects.

Hereinafter, preferred embodiments of the present invention will be described in more detail with reference to the accompanying drawings.

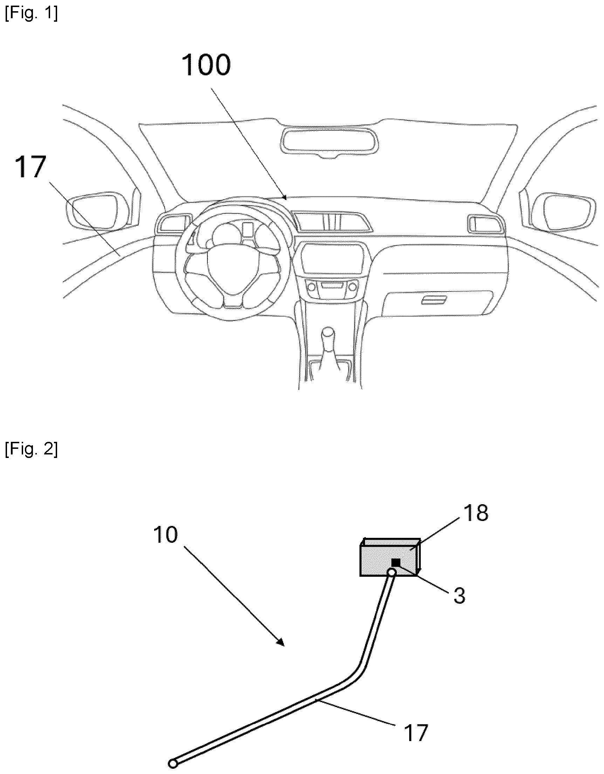

Figure 1 shows a luminous device according to the invention installed in an automotive vehicle 100.

This luminous device comprises a plurality of light emitting diodes (LEDs) which emit light and a lightguide 17 which projects the light to the interior of the vehicle 100.

Figure 2 shows a general approach of a particular embodiment of a luminous device according to the invention.

As can be seen in this figure, the luminous device 10 comprises a RGB module 18 which comprises the electronic arrangement including a group of LEDs 3. These LEDs 3 emit light which is projected by the light guide 17. The RGB module 18 receives the power supply and instructions from a vehicle connector which in turn receives communication from the Body Control Module of the vehicle.

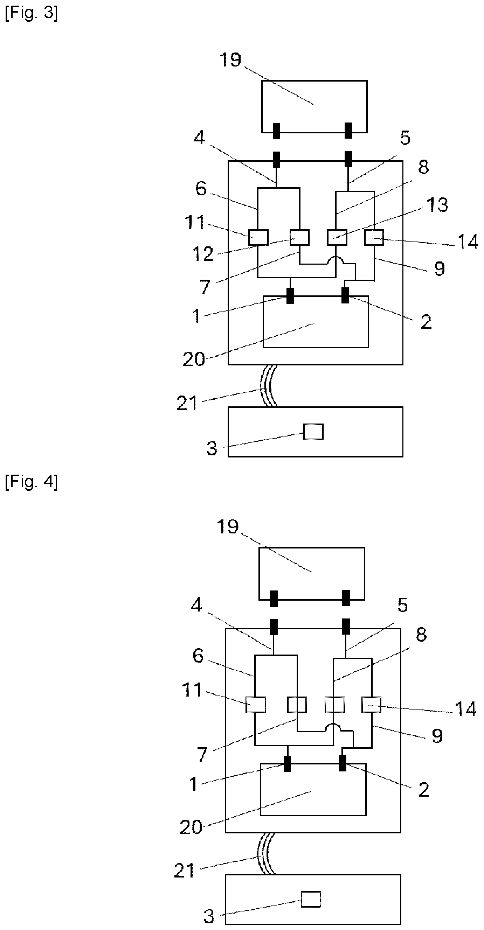

Figure 3 shows the electric arrangement of a particular embodiment of a luminous device according to the invention.

This electric arrangement includes a first printed circuit board and a second printed circuit board. The first printed circuit board comprises a first circuit and a second circuit, which are coupled. The first circuit comprises a driver element 20, which is in charge of controlling the LED 3. The LED is located in the second printed circuit board, and is connected to the first printed circuit board by means of a harness 21. The second circuit is intended to provide the physical connection with a vehicle connector 19 provided by the car manufacturer.

The first circuit comprises a first circuit input 1, a second circuit input 2 and the aforementioned driver element 20. The first circuit input 1 is configured to receive a VCC signal, while the second circuit input 2 is configured to receive a GND signal.

This illustration is provided as a simplified example, the first circuit may provide several further circuit inputs, with different functions. However, for the sake of clarity in the exposition of the invention, only these two circuit inputs 1, 2, are described. The second circuit comprises a first coupling input 4 and a second coupling input 5. These inputs are directly connected to the pins of the vehicle connector. Hence, these coupling inputs do not have a predetermined function; each one may receive a VCC signal or a GND signal, depending on the car manufacturer.

To solve this problem, the second circuit also comprises a first connection 6, a second connection 7, a third connection 8, and a fourth connection 9. The first connection 6 provides an electric connection from the first coupling input 4 to the first circuit input 1, the second connection 7 provides an electric connection from the first coupling input 4 to the second circuit input 2, the third connection 8 provides an electric connection from the second coupling input 5 to the first circuit input 1, and the fourth connection 9 provides an electric connection from the second coupling input 5 to the second circuit input 2.

As may be seen in this figure, the second connection 7 crosses the third connection 8. Since these two connections must not be in electric contact, the printed circuit board comprises a first layer and a second layer, and the second connection comprises a via which connects a point in the first layer with a point in the second layer, and another via to take the connection back to the first layer.

As can be seen, all of these connections 6, 7, 8, 9 comprises an electric discontinuity 11, 12, 13, 14: all of the circuits are open, and only the connections required for a particular variant of a vehicle will be closed. When the car manufacturer provides the information about the signal that is provided in each pin of the vehicle connector, the appropriate connections will be shorted.

Figure 4 shows the electric arrangement of Figure 3 in a particular embodiment of use.

In this example, the interior lighting functionality of a type of car requires that the vehicle connector 19 will provide the GND signal in the first pin (which is intended to be coupled to the first coupling input 4) and the VCC signal in the second pin (which is intended to be coupled to the second coupling input 5). Since the PCB of the luminous device has a setting where the first circuit input 1 is configured to receive a VCC signal and the second circuit input 2 is configured to receive a GND signal, in this example, the first coupling input 4 is configured to be connected to the second circuit input 2 and the second coupling input 5 is configured to be connected to the first circuit input 1.

To close the necessary circuit paths, a jumper can be installed in the discontinuity of the second connection 7, and an additional jumper can be installed in the discontinuity of the third connection 8. In an embodiment, the jumper is a zero ohm resistor that can be Surface Mounted (SMD) on the PCB to close the circuit. In another embodiment, the jumper is a zero ohm resistor that can be mounted on the PCB by a through hole. In another embodiment, the jumper can be a cable.

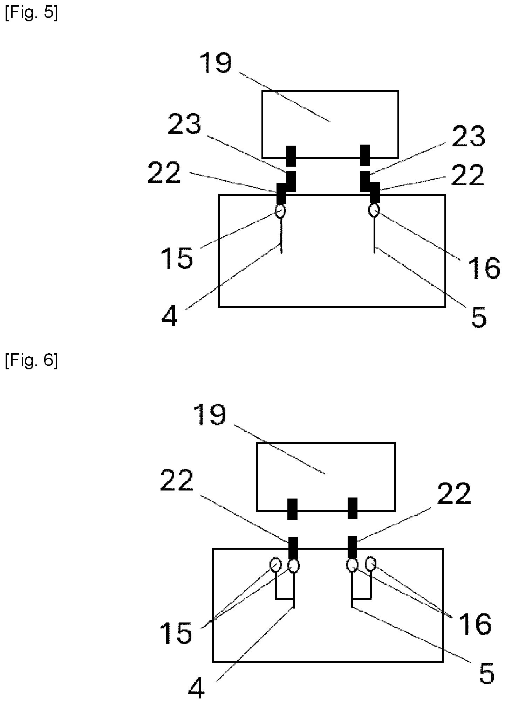

Figure 5 shows the electric arrangement of a different luminous device according to the invention.

In this case, the second circuit comprises a first pinhole 15 and a second pinhole 16. The first pinhole 15 is electrically connected to the first coupling input 4 and the second pinhole 16 is electrically connected to the second coupling input 5.

A pinhole is a hole which is adapted to receive a pin 22. With the configuration of the present invention, a first pin 22 will be inserted in the first pinhole 15 and a second pin 22 will be inserted in the second pinhole 16. Each pin 22 has an insertion portion and a connection portion, and the connection portion is bended so that the distance between the tips 23 of the connection portions fits with the distance established by the pins of the vehicle connector 19.

Figure 6 shows the electric arrangement of a different luminous device according to the invention.

In this case, the second circuit comprises two first pinholes 15 and two second pinholes 16. The first pinholes 15 are electrically connected to the first coupling input 4 and the second pinholes 16 are electrically connected to the second coupling input 5.

With the configuration of the present invention, a first pin 22 will be inserted in one of the first pinholes 15 and a second pin 22 will be inserted in one of the second pinholes 16. The choice between the different pinholes will be determined by the distance between the two pins of the vehicle connector.

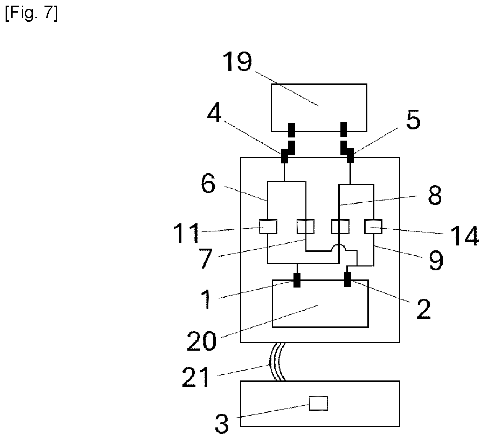

Figure 7 shows a combination between the arrangement of Figure 4 and the arrangement of Figure 6.

In this case, the second circuit comprises two first pinholes 15 and two second pinholes 16. The first pinholes 15 are electrically connected to the first coupling input 4 and the second pinholes 16 are electrically connected to the second coupling input 5.

With the configuration of the present invention, a first pin will be inserted in one of the first pinholes 15 and a second pin will be inserted in one of the second pinholes 16. The choice between the different pinholes will be determined by the distance between the two pins of the vehicle connector.

In an example embodiment, the distance between the exterior first pinhole and the exterior second pinhole is 2.2 mm, while the distance between the interior first pinhole and the interior second pinhole is 1.8 mm. Since the vehicle connector provides a separation between pins of 2.2 mm, the exterior pinholes will receive a pin, while the interior pinholes will be empty.

In this example, the interior lighting functionality of a type of car requires that the vehicle connector will provide the GND signal in the first pin (which is intended to be coupled to the first coupling input 4) and the VCC signal in the second pin (which is intended to be coupled to the second coupling input 5). Since the printed circuit board of the luminous device has a setting where the first circuit input 1 is configured to receive a VCC signal and the second circuit input 2 is configured to receive a GND signal, in this example, the first coupling input 4 should be connected to the second circuit input 2 and the second coupling input 5 should be connected to the first circuit input 1.

To do so, a jumper is installed in the discontinuity of the second connection 7 and another jumper is installed in the discontinuity of the third connection 8.

## Claims

1. Luminous device (10) for interior lighting of a vehicle, the luminous device comprising a circuit substrate, wherein
the circuit substrate comprises a first circuit, a second circuit, and a light source (3);
the first circuit comprises a first circuit input (1), a second circuit input (2) and a driver element (20) configured to control the light source (3);
the second circuit comprises a first coupling input (4), a second coupling input (5), a first connection (6), a second connection (7), a third connection (8) and a fourth connection (9);
the first connection (6) provides an electric connection from the first coupling input (4) to the first circuit input (1) and comprises a first electric discontinuity (11);
the second connection (7) provides an electric connection from the first coupling input (4) to the second circuit input (2) and comprises a second electric discontinuity (12);
the third connection (8) provides an electric connection from the second coupling input (5) to the first circuit input (1) and comprises a third electric discontinuity (13); and
the fourth connection (9) provides an electric connection from the second coupling input (5) to the second circuit input (2) and comprises a fourth electric discontinuity (14).

2. Luminous device (10) according to claim 1, wherein the second circuit comprises at least two first pinholes (15) and at least two second pinholes (16), wherein the first pinholes (15) are electrically connected to the first coupling input (4) and the second pinholes (16) are electrically connected to the second coupling input (5).

3. Luminous device (10) according to claim 2, wherein the distance between one of the first pinholes and one of the second pinholes is 1.8 mm or 2.1 mm or 2.54 mm.

4. Luminous device (10) according to any one of claims 2 or 3, further comprising at least one pin (22), each pin (22) being inserted in one of the pinholes (15, 16), wherein the pin (22) comprises an insertion portion and a connection portion, and the connection portion is bended so that the distance between the tips (23) of the connection portions is greater or lower than the distance between the corresponding pinholes (15, 16).

5. Luminous device (10) according to any one of the preceding claims, wherein the first coupling input (4) is a supply terminal and the first circuit input (1) or the second circuit input (2) is a supply terminal.

6. Luminous device (10) according to any one of the preceding claims, wherein the second coupling input (5) is a ground terminal and the first circuit input (1) or the second circuit input (2) is a ground terminal.

7. Luminous device (10) according to any one of the preceding claims, wherein
the circuit substrate comprises at least a first layer and a second layer, and
at least one of the first connection (6), the second connection (7), the third connection (8) and the fourth connection (9) comprises a via which connects a point in the first layer with a point in the second layer.

8. Luminous device (10) according to any one of the preceding claims, wherein at least one of the first connection, the second connection, the third connection and the fourth connection comprises a jumper installed in the corresponding electric discontinuity, which closes the electric discontinuity.

9. Luminous device (10) according to any one of the preceding claims, the luminous device further comprising an optical element configured to receive the light emitted by the light source.

10. Luminous device (10) according to claim 9, wherein the optical element is a lightguide or a reflector or a massive light guide.

11. Luminous device (10) according to any one of the preceding claims, wherein the light source is a solid-state light source, such as a light emitting diode.

12. Luminous device (10) according to any one of the preceding claims, further comprising a second circuit substrate, wherein the light source is arranged in the second circuit substrate, and the light source is connected to the driver element by means of a harness (21).
